# EUROPÄISCHE PATENTSCHRIFT

(11) **EP 1 198 797 B1**
(45) Veröffentlichungstag und Bekanntmachung des Hinweises auf die Patenterteilung: **02.05.2003**
(21) Anmeldenummer: 00942097.7
(22) Anmeldetag: 19.06.2000
(51) Int. Cl.: G11C 11/00

(54) **HALBLEITERSPEICHER-CHIPMODUL**
SEMICONDUCTOR MEMORY CHIP MODULE
MODULE MICROPLAQUETTE SEMI-CONDUCTRICE

(30) Priorität: 23.06.1999 DE 19928733
(43) Veröffentlichungstag der Anmeldung: 24.04.2002
(73) Patentinhaber: Giesecke & Devrient GmbH, 81677 München (DE)
(72) Erfinder: GRASSL, Thomas, D-85354 Freising (DE)
(86) Internationale Anmeldenummer: EP0005625
(87) Internationale Veröffentlichungsnummer: WO01001418

(56) Entgegenhaltungen:
- EP-A- 0 328 062
- US-A- 5 229 647
- US-A- 5 840 417
- US-A- 5 973 396

## Beschreibung

Die Erfindung betrifft ein Halbleiterspeicher-Chipmodul mit mehreren Speicherchips unterschiedlicher Typen, insbesondere mit mehreren in unterschiedlicher Fertigungstechnologie ausgeführten Speicherchips. Insbesondere betrifft die Erfindung ein für Chipkarten geeignetes Halbleiterspeicher-Chipmodul und eine mit einem solchen Chipmodul ausgestattete Chipkarte.

Man kann die derzeit verfügbaren Halbleiterspeicher abhängig von ihrer Fertigungstechnologie, ihren Betriebsparametern, ihrer Kapazität etc. verschiedenen Typen zuordnen. Man kann Halbleiterspeicher zum Beispiel unterscheiden in flüchtige und in nicht-flüchtige Speicher.

Zweckmäßigerweise werden in Chipkarten und in Chipkarten-Terminals nicht-flüchtige Speicher verwendet, deren Inhalt aber auch gelöscht und überschrieben werden kann. Typischerweise verwendete Halbleiterspeicher für diese Zwecke sind EEPROMs.

Solche EEPROMs, also löschbare, elektrisch programmierbare Festspeicher, machen zum Löschen und zum erneuten Einschreiben von Daten einigen schaltungstechnischen Aufwand erforderlich und benötigen im Vergleich zu flüchtigen Speichern, beispielsweise einem DRAM oder SRAM, relativ viel Zugriffszeit. Wird ein solcher Halbleiterspeicher bei der Abarbeitung von Software-Programmen eingesetzt, so ist eine nur langsame Abarbeitung für das Programm möglich. Hinzu kommt, daß bei einem EEPROM nur eine begrenzte Anzahl von Lösch- und Schreibvorgängen möglich ist, typischerweise in der Größenordnung von 10.000 bis 100.000.

Ist man auf das Vorhandensein eines nicht-flüchtigen Speichers, zum Beispiel eines EEPROMs, angewiesen, und möchte aber dennoch einen Speicher mit schnellem Zugriff für die Programm-Abarbeitung zur Verfügung haben, so kann man daran denken, zusätzlich zu dem EEPROM zum Beispiel einen SRAM als flüchtigen Speicher vorzusehen, mit dessen Hilfe dann die Programm-Abarbeitung erfolgt. Will man nach Ausführung eines Programms die Ergebnisse für längere Zeit speichern, so kann man eine Umladung der benötigten Daten in den EEPROM vornehmen.

Die unterschiedlichen Halbleiterspeicher-Typen, das heißt im vorliegenden Fall nicht-flüchtiger Speicher (EEPROM) und schneller flüchtiger Speicher (SRAM) basieren auf unterschiedlicher Fertigungstechnologie. Verwendet man zwei solche verschiedenen Halbleiterspeicher-Typen nebeneinander, so ist ein erheblicher Aufwand erforderlich, um die beiden Speicher funktionstüchtig miteinander zu verbinden. Zwischen den beiden Speichern sind relativ lange Leitungswege erforderlich. Dies benötigt einen relativ großen Anteil der verfügbaren Chipfläche.

In DE 196 26 337 A1 wird die gleichzeitige Verwendung von Chips mit flüchtigen und nicht-flüchtigen Speichern für die Datenspeicherung beschrieben. In EP 0 328 062 A2 wird dabei von der Verwendung in einer Chipkarte ausgegangen, so daß EP 0 328 062 A2 die Merkmale des Oberbegriffs der nebengeordneten Ansprüche aufweist. Beiden Dokumenten ist jedoch nichts über den geometrischen Aufbau oder die Anordnung der Chips zu entnehmen.

US 5,840,417 beschreibt allgemein die vertikale Anordnung und Kontaktierung von elektronischen Chips, wohingegen in US 5,229,647 die vertikale Anordnung und Kontaktierung von gleichartigen Speicherchips beschrieben wird. Auf die sich aus der Verwendung unterschiedlicher Speicherchip-Typen ergebenden Probleme wird in keinem der beiden Dokumente eingegangen.

Der Erfindung liegt die Aufgabe zugrunde, ein Halbleiterspeicher-Chipmodul anzugeben, bei dem sich die Vorteile zweier Speicherchip-Typen ohne die genannten Nachteile, das heißt hoher Herstellungsaufwand und lange Leitungswege, erreichen läßt.

Diese Aufgabe wird durch die Merkmale des Anspurchs 1 gelöst. Erfindungsgemäß wird ein Halbleiterspeicher-Chipmodul mit unterschiedlichen Speicherchip-Typen dadurch geblidet, daß die Speicherchips in verschiedene Ebenen übereinander angeordnet sind und über Vertikal-Zwischenverbindungen verbunden sind.

In einer besonders bevorzugten Ausführungsform gibt es.eine feste Zuordnung von Speicherzellen des ersten Speicherchips zu Speicherzellen des zweiten Speicherchips, wobei die einander zugeordneten Speicherzellen direkt miteinander über die vertikalen Verbindungen verbunden sind.

In einer besonders bevorzugten Ausführungsform handelt es sich bei dem ersten Typ von Speicherchip um einen nicht-flüchtigen Speicher, insbesondere EEPROM, bei dem zweiten Typ um einen flüchtigen Speicher, zum Beispiel einen SRAM.

Die Erfindung gestattet die Herstellung eines Halbleiterspeicher-Chipmoduls mit unterschiedlichen Typen von Speicherchips, insbesondere nach verschiedenen Herstellungstechnologien gefertigten Speicherchips. Die Chips können erfindungsgemäß getrennt hergestellt werden - mit Hilfe der für sie typischen Fertigungsprozesse. Die fertigen Chips benötigen jeweils für sich nur relativ wenig Chipfläche. Die fertigen Chips werden dann übereinandergestapelt, wobei die Verbindungen zwischen den Chips Vertikal-Verbindungen sind, also nur sehr wenig zusätzliche Chipfläche in Anspruch nehmen. Der Chip-Stapel wird dann als geschlossene Einheit ausgebildet, insbesondere zu einem Baustein gekapselt, so daß er in eine Chipkarte eingebaut werden kann.

In der einfachsten Ausführungsform der Erfindung können zwei Chipebenen vorgesehen sein. Da zu jedem Halbleiterspeicher außer den eigentlichen Speicherzellen noch eine Ansteuerschaltung gehört, hier als Dekoder bezeichnet, kann man diese Dekoder mit dem jeweiligen Halbleiterchip gemeinsam ausbilden. In einer besonders vorteilhaften Ausgestaltung der Erfindung ist aber vorgesehen, daß in einer weiteren Ebene ein weiterer Chip mit Dekoderschaltungen für sämtliche Speicherchips des Chipmoduls vorgesehen ist. Die Chipbelegungsfläche wird also - in horizontaler Richtung - nicht vergrößert durch die Dekoderschaltungen in dem weiteren Chip. Auch der Chip mit den Dekoderschaltungen ist durch Vertikal-Zwischenchipverbindungen an das Speicherchip des ersten oder des zweiten Typs angeschlossen, je nachdem, welcher Chip sich direkt unter dem Chip mit den Dekoderschaltungen befindet.

Eine Besonderheit bei der Verwendung von Speicherchips in Verbindung mit Chipkarten und Chipkarten-Terminals ist die Abwehr von sogenannten Power-Analysis-Angriffen. Bei derartigen Angriffen wird in betrügerischer Absicht versucht, mit Hilfe spezieller Sensoren Strom- und Spannungszustände an einer Schaltung zu analysieren, um dadurch Rückschlüsse auf geschützte Daten ziehen zu können. Wird an sämtlichen Anschlüssen für Spannungs- und Strompegel gesorgt, die unabhängig von internen Schaltungszuständen stets einen oder einen von mehreren definierten Pegeln einnehmen, so ist ein derartiger Angriff nicht möglich.

Man kann mit Hilfe eines ständig nachgeladenen Kondensators, eines sogenannten Pufferkondensators, die Versorgungsspannung für den Chip soweit glätten, daß nach außen keine Pegeländerungen erkennbar sind, die Rückschlüsse auf Schaltungszustände zulassen könnten.

In einer bevorzugten Ausgestaltung der Erfindung ist vorgesehen, daß in mindestens einer der Ebenen des Chipmoduls ein Energiepuffer, insbesondere in Form eines integrierten Kondensators ausgebildet ist. Dieser Pufferkondensator kann eine gesamte Chip-Ebene belegen, bei bevorzugter mehrlagiger Ausbildung kann er aber auch nur auf eine Teil-Chipfläche beschränkt werden, so daß der Rest dieser Ebene dann für Speicherzellen, Dekoderschaltungen oder Logikschaltungen zur Verfügung steht. Dieser Pufferkondensator kann dann dazu benutzt werden, am Ende der Bearbeitung eines Programms, durchgeführt mit Hilfe des flüchtigen Speichers, die Ergebnisse des Programms und weitere Daten in dem nicht flüchtigen Speicher abzuspeichern. Bei einem zum Beispiel durch äußere Störeinflüsse hervorgerufenen Programmabbruch können die zum Neu-Starten des Programms erforderlichen Daten mit Hilfe des Pufferkondensators in dem nicht-flüchtigen Speicher dauerhaft abgespeichert werden.

Im folgenden werden Ausführungsbeispiele der Erfindung anhand der Zeichnung näher erläutert. Es zeigen:
Figur 1 eine schematische Vertikal-Schnittansicht durch ein Halbleiterspeicher-Chipmodul gemäß einer ersten Ausführungsform der Erfindung; und
Figur 2 eine ähnliche Darstellung wie Figur 1 einer zweiten Ausführungsform der Erfindung.

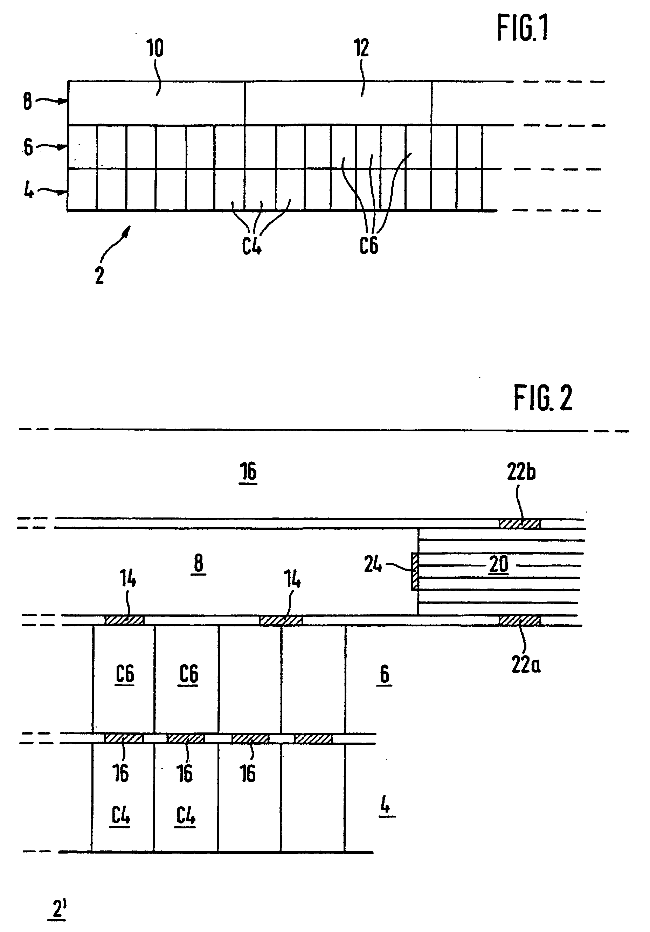

Figur 1 zeigt ein Halbleiterspeicher-Chipmodul 2 gemäß einer ersten Ausführungsform der Erfindung. Das Chipmodul 2 enthält drei übereinandergestapelte Chips, nämlich einen unteren Chip 4, hier als EEPROM, also als nicht-flüchtiger Speicherchip ausgebildet, einen mittleren Chip 6, hier als SRAM, also als flüchtiger Speicherchip ausgebildet, und einen oberen Chip 8, welcher zwei Typen von Dekoderschaltungen 10 und 12 beinhaltet.

In dem Speicherchip 4 ist eine vorbestimmte Anzahl von Speicherzellen C4 ausgebildet, mit diesen in vertikaler Richtung fluchtend enthält der Speicherchip 6 eine entsprechende Anzahl von flüchtigen Speicherzellen C6.

Die Speicherzellen C4 und C6 in den Speicherchips 4 bzw. 6 sind vertikal ausgerichtet, wie durch senkrechte Striche in Figur 1 angedeutet ist. Es besteht zwischen den jeweils einander vertikal zugeordneten Speicherzellen C4 und C6 eine direkte elektrische Verbindung durch sogenannte Vertikal-Zwischenchipverbindungen, die weiter unten für das in Figur 2 gezeigte Ausführungsbeispiel noch näher erläutert werden.

Die in der oberen Ebene in dem oberen Chip 8 enthaltenen Dekoderschaltungen 10 und 12 ermöglichen verschiedene Adressierungsmöglichkeiten für die Speicherchips 4 und 6. Bei der vorhandenen Ausführungsform dienen die Dekoderschaltungen 10 (in Figur 1 ist nur eine dargestellt) zur Ansteuerung der Speicherzellen C4 in dem unteren Speicherchip 4, die Dekoderschaltungen 12 dienen zum Ansteuern der Speicherzellen C6 in den mittleren Speicherchip 6. In einer abgewandelten Ausführungsform können die Dekoderschaltungen 10 und 12 jedoch auch jeweils für beide Speicherchips 4 und 6 verwendet werden.

Figur 2 zeigt eine zweite Ausführungsform eines Halbleiterspeicher-Chipmoduls 2', welches aufbauend auf dem in Figur 1 gezeigten Chipmodul strukturiert ist.

Wie bei der ersten Ausführungsform ist ein unterer Speicherchip 4 als EEPROM ausgebildet, darüber befindet sich in der nächsten Ebene ein als SRAM ausgebildeter Speicherchip 6. Die miteinander vertikal fluchtenden Speicherzellen C4 und C6 sind über Vertikal-Zwischenchipverbindungen 16 direkt elektrisch verbunden.

Über ähnliche Vertikal-Zwischenchipverbindungen ist der Speicherchip 6 mit dem Chip 8 verbunden, welcher nicht näher dargestellte Dekodierschaltungen und zusätzlich einen Pufferkondensator 20 enthält. Der Pufferkondensator 20 ist ebenfalls über direkte Vertikal-Zwischenchipverbindungen 22a mit dem darunter liegenden Speicherchip 6 und über Zwischenchipverbindungen 22b mit einem darüber liegenden weiteren Chip 16 verbunden, er ist außerdem über eine bei 24 angedeutete Verbindung mit den in dem Chip 8 enthaltenen Dekoderschaltungen verbunden. Durch nicht dargestellte Durchgangsverbindungen steht der Pufferkondensator 20 auch mit dem unteren Speicherchip 4 in Verbindung.

Bei dem Halbleiterspeicher-Chipmodul 2' der in Figur 2 gezeigten Ausführungsform ist außer dem Pufferkondensator 20, der als Energiepuffer fungiert, noch in einer obersten Ebene der Chip 16 vorhanden, der zum Beispiel Logikschaltungen enthält, deren Funktion für sämtliche der übrigen Chips 4, 6 und 8 verfügbar ist.

Bei der Ausführungsform nach Figur 2 ist der Pufferkondensator 20 aus mehreren abwechselnden elektrisch leitenden bzw. Dielektrikum-Lagen hergestellt. Von einer nicht dargestellten Speiseleitung wird der Pufferkondensator 20 ständig auf einem Versorgungsspannungspegel gehalten. Seine Kapazität ist derart bemessen, daß er im Fall beispielsweise eines Betriebsabbruchs des Chipmoduls 2' das Schreiben von Daten aus dem SRAM des Speicherchips 6 in entsprechende Speicherzellen des EEPROMs des Speicherchips 4 erlaubt.

Die Erfindung und die in den Figuren 1 und 2 dargestellten Ausrührungsformen eines Chipmoduls eignen sich insbesondere für den Einbau in eine Chipkarte oder ein Chipkarten-Terminal, wenngleich die Erfindung nicht hierauf beschränkt ist. Als weitere Abwandlung der Erfindung kann die Reihenfolge der Speicherchips geändert werden, in Figur 1 können zum Beispiel die verschiedenen Chips 4, 6 und 8 in ihrer Reihenfolge ausgetauscht werden. Das gleiche gilt für die Anordnung nach Figur 2. Der Pufferkondensator 20 kann sich auch über eine gesamte Chipebene erstrecken. Die Dekoderschaltungen, in Figur 1 in dem oberen Chip 8 bei 10 und 12 dargestellt, können auch auf verschiedene Chipebenen verteilt werden.

Die in den Figuren 1 und 2 dargestellten Ausführungsbeispiele von Halbleiterspeicher-Chipmodulen enthalten die in separaten Herstellungsprozessen gefertigten Chips 4, 6, 8 und 16. Die separat gefertigten Chips werden übereinandergestapelt und durch Bonden vertikal miteinander verbunden. Unter Bonden wird in diesem Fall das Verbinden der einzelnen Chips bzw. Chips enthaltende Wafer verstanden. Dazu können die Chips bzw. Wafer gedünnt sein, d. h. ihre Dicke wird nach der Herstellung verringert. Die eigentliche elektrische Verbindung der einzelnen Chips bzw. Wafer untereinander erfolgt - wie oben beschrieben - mittels Vertikal-Zwischenchipverbindungen. Die Vertikal-Zwischenchipverbindungen werden dabei mittels eines Metallisierungsprozesses hergestellt, der dem Metallisierungsprozess bei der Herstellung der einzelnen Chips bzw. Wafer entspricht. Dadurch kann eine hohe Verbindungsdichte erreicht werden, die es z. B. erlaubt, wie oben beschrieben, einzelne Speicherzellen in unterschiedlichen Ebenen, d. h. auf unterschiedlichen Chips, miteinander elektrisch zu verbinden. Dies bewirkt zudem eine Erhöhung der Sicherheit, da die internen Vertikal-Zwischenchipverbindungen nicht von außen zugänglich sind und somit nicht zu Analysezwecken abgeriffen werden können.

Die so erhaltene gesamte Anordnung wird eingekapselt und steht dann für den Einbau in zum Beispiel eine Chipkarte zur Verfügung. Das Einkapseln einschließlich der nach außen geführten Verbindungsanschlüsse wird hier - weil konventionell - nicht näher erläutert.

Eingebaut in eine Chipkarte arbeitet das Halbleiterspeicher-Chipmodul gemäß Figur 1 oder Figur 2 dann so, daß die dauerhaft gespeicherten Daten sich in dem unteren Chip 4, das heißt in dem nicht-flüchtigen Speicher EEPROM, befinden. Bei Ausführung von Programmen werden benötigte Daten in den mittleren Chip, das heißt den flüchtigen Speicher (SRAM) umgeladen. Der mittlere Chip 6 fungiert dann wie ein Cache-Speicher. Ergebnisdaten und bei beispielsweise einem Betriebsabbruch zu sichernde Daten werden dann von dem mittleren Speicherchip 6 in den unteren Speicherchip 4 umgeladen, wozu die im Pufferkondensator gespeicherte Energie verwendet wird.

## Patentansprüche

1. Halbleiterspeicher-Chipmodul, mit einem ersten Speicherchip (4) eines ersten Typs, einem zweiten Speicherchip (6) eines zweiten Typs, und einer elektrischen Verbindung (14,16) zwischen dem ersten und dem zweiten Speicherchip (4,6), **dadurch gekennzeichnet, daß** die Speicherchips (4, 6) unterschiedlichen Typs in verschiedenen Ebenen übereinander angeordnet und über Vertikal-Zwischenchipverbindungen (14,16) verbunden sind.

2. Chipmodul nach Anspruch 1, **dadurch gekennzeichnet, daß** Speicherzellen (C4) des ersten Speicherchips (4) bestimmten Speicherzellen (C6) des zweiten Speicherchips (6) fest zugeordnet sind, und die einander zugeordneten Speicherzellen (C4, C6) direkt miteinander elektrisch verbunden sind.

3. Chipmodul nach Anspruch 1 oder 2, **dadurch gekennzeichnet, daß** der erste Typ einem nicht-flüchtigen Speicher, zum Beispiel EEPROM, und der zweite Typ einem flüchtigen Speicher, zum Beispiel SRAM, entspricht.

4. Chipmodul nach einem der Ansprüche 1 bis 3, **dadurch gekennzeichnet, daß** mindestens ein weiterer Chip (8,16) in einer weiteren Ebene vorgesehen ist.

5. Chipmodul nach Anspruch 4, **dadurch gekennzeichnet, daß** der weitere Chip Dekoderschaltungen (10,12) für die Speicherchips (4,6) enthält.

6. Chipmodul nach einem der Ansprüche 1 bis 5, **dadurch gekennzeichnet, daß** ein Energiepuffer in mindestens einer der Ebenen ausgebildet ist.

7. Chipmodul nach Anspruch 6, **dadurch gekennzeichnet, daß** der Energiepuffer als integrierter Pufferkondensator (20) ausgebildet ist.

8. Chipmodul nach einem der Ansprüche 1 bis 7, ausgebildet für eine Chipkarte.

9. Chipkarte mit einem Halbleiterspeicher-Chipmodul nach einem der Ansprüche 1 bis 8.

## Claims

1. A semiconductor memory chip module having a first memory chip (4) of a first type, a second memory chip (6) of a second type, and an electric connection (14, 16) between the first and second memory chips (4, 6), **characterized in that** the memory chips (4, 6) are disposed one above the other in different levels and connected by vertical chip interconnections (14, 16).

2. A chip module according to claim 1, **characterized in that** memory cells (C4) of the first memory chip (4) are firmly allocated to certain memory cells (C6) of the second memory chip (6), and the mutually allocated memory cells (C4, C6) are directly interconnected electrically.

3. A chip module according to claim 1 or 2, **characterized in that** the first type corresponds to a nonvolatile memory, for example EEPROM, and the second type to a volatile memory, for example SRAM.

4. A chip module according to any of claims 1 to 3, **characterized in that** at least one further chip (8, 16) is provided in a further level.

5. A chip module according to claim 4, **characterized in that** the further chip contains decoder circuits (10, 12) for the memory chips (4, 6).

6. A chip module according to any of claims 1 to 5, **characterized in that** an energy buffer is formed in at least one of the levels.

7. A chip module according to claim 6, **characterized in that** the energy buffer is formed as an integrated buffer capacitor (20).

8. A chip module according to any of claims 1 to 7, formed for a smart card.

9. A smart card having a semiconductor memory chip module according to any of claims 1 to 8.

## Revendications

1. Module à puces mémoire de semi-conducteur, avec une première puce mémoire (4) d'un premier type, une deuxième puce mémoire (6) d'un deuxième type, et une liaison électrique (14, 16) entre la première et la deuxième puce mémoire (4, 6), **caractérisé en ce que** les puces mémoire (4, 6) de types différents sont disposées dans des plans différents l'une au-dessus de l'autre et reliées au moyen de liaisons verticales (14, 16) entre puces.

2. Module à puces selon la revendication 1, **caractérisé en ce que** les cellules mémoire (C4) de la première puce mémoire (4) sont fixées à des cellules mémoire (C6) de la deuxième puce mémoire (6) et **en ce que** les cellules mémoire (C4, C6) sont directement reliées les unes aux autres électriquement.

3. Module à puces selon la revendication 1 ou 2, **caractérisé en ce que** le premier type correspond à une mémoire non volatile, par exemple une EEPROM, et le deuxième type à une mémoire volatile, par exemple une SRAM.

4. Modulé à puces selon l'une des revendications 1 à 3, **caractérisé en ce qu'**au moins une puce supplémentaire (8, 16) est prévue dans un plan supplémentaire.

5. Module à puces selon la revendication 4, **caractérisé en ce que** la puce supplémentaire contient des circuits décodeurs (10, 12) pour les puces mémoire (4, 6).

6. Module à puces selon l'une des revendications 1 à 5, **caractérisé en ce qu'**un tampon d'énergie est monté sur au moins l'un des plans.

7. Module à puces selon la revendication 6, **caractérisé en ce que** le tampon d'énergie est formé d'un condensateur tampon intégré (20).

8. Module à puces selon l'une des revendications 1 à 7, conçu pour une carte à puce.

9. Carte à puces avec un module à puces mémoire semi-conducteur selon l'une des revendications 1 à 8.
